(19) Europäisches Patentamt
European Patent Office
Office européen des brevets

(11) **EP 3 191 337 B1**

(12) **FASCICULE DE BREVET EUROPEEN**

(45) Date de publication et mention
de la délivrance du brevet:
**07.11.2018 Bulletin 2018/45**

(21) Numéro de dépôt: **15767217.1**

(22) Date de dépôt: **02.09.2015**

(51) Int Cl.:
*B60L 11/14* (2006.01)          *B60L 11/18* (2006.01)
*H02J 7/00* (2006.01)          *G01R 31/36* (2006.01)
*H01M 10/44* (2006.01)          *B60R 16/033* (2006.01)
*H01M 10/42* (2006.01)          *H01M 10/48* (2006.01)

(86) Numéro de dépôt international:
**PCT/FR2015/052318**

(87) Numéro de publication internationale:
**WO 2016/038276 (17.03.2016 Gazette 2016/11)**

(54) **PROCÉDÉ DE GESTION DE LA PLAGE D'UTILISATION D'UNE BATTERIE**

VERFAHREN ZUR VERWALTUNG DES BETRIEBSBEREICHS EINER BATTERIE

METHOD FOR MANAGING THE OPERATING RANGE OF A BATTERY

(84) Etats contractants désignés:
**AL AT BE BG CH CY CZ DE DK EE ES FI FR GB
GR HR HU IE IS IT LI LT LU LV MC MK MT NL NO
PL PT RO RS SE SI SK SM TR**

(30) Priorité: **10.09.2014 FR 1458508**

(43) Date de publication de la demande:
**19.07.2017 Bulletin 2017/29**

(73) Titulaire: **Renault S.A.S.**
**92100 Boulogne (FR)**

(72) Inventeurs:
• **SAINT-MARCOUX, Antoine**
**F-91120 Palaiseau (FR)**
• **DELOBEL, Bruno**
**92130 Issy-Les-Moulineaux (FR)**

(56) Documents cités:
**JP-A- 2014 096 958      US-A1- 2012 112 754
US-A1- 2013 184 913**

• **Anonymous: "State of health - Wikipedia, the free
encyclopedia", , 7 mars 2014 (2014-03-07),
XP055191086, Wikipedia Extrait de l'Internet:
URL:http://en.wikipedia.org/w/index.php?ti
tle=State_of_health&oldid=598585672 [extrait le
2015-05-21]**
• **SPOTNITZ R: "Simulation of capacity fade in
lithium-ion batteries", JOURNAL OF POWER
SOURCES, ELSEVIER SA, CH, vol. 113, no. 1, 1
janvier 2003 (2003-01-01), pages 72-80,
XP004399047, ISSN: 0378-7753, DOI:
10.1016/S0378-7753(02)00490-1**

**Description**

L'invention concerne un procédé de gestion de la plage d'utilisation d'une batterie d'accumulateurs électriques.

Un domaine d'application envisagé est notamment, mais non exclusivement, la gestion des batteries lithium-ion utilisées dans les véhicules électriques, hybrides ou hybrides rechargeables. Ce type de batterie comporte une pluralité d'accumulateurs électriques ou cellules, incluant un système électrochimique rechargeable destiné à fournir une tension nominale.

La plage d'utilisation de la batterie correspond à la plage d'état de charge autorisée pour la batterie, tant en charge qu'en décharge. Cette plage d'utilisation se caractérise d'une part, par un état de charge maximal, correspondant à un état de charge au-dessus duquel la batterie n'est pas autorisée à monter, et, d'autre part, par un état de charge minimal, au-dessous duquel la batterie n'est pas autorisée à descendre.

L'état de charge maximal autorisé est défini par la tension de fin de charge wou tension de coupure, qui peut, par exemple, être mesurée aux bornes de la batterie. En effet, cette tension est représentative de la limite de charge des cellules constitutives de la batterie. Autrement dit, c'est la valeur que doit atteindre la tension maximale aux bornes de chaque cellule en fin de charge pour juger que la charge est bien terminée. Une tension de fin de charge élevée accroît l'énergie disponible en début de vie de la batterie mais entraîne par contre un vieillissement plus rapide de la batterie. Aussi, pour la gestion de la tension de fin de charge, il est nécessaire de trouver un compromis entre le niveau d'énergie assuré par la batterie à court terme et la durabilité de la batterie.

On observera que le problème de la gestion de l'état de charge minimal de la batterie se pose avec la même acuité. En effet, si l'état de charge minimal est trop élevé, l'énergie disponible pour l'utilisateur ne sera pas au niveau souhaité par rapport à un niveau d'énergie minimal requis, tandis que s'il est trop bas, dans certains cas d'usage, en particulier dans des conditions de températures froides, la batterie risque de se retrouver à un niveau d'état de charge où elle sera incapable de fournir le niveau de puissance minimal requis. Aussi, pour la gestion de l'état de charge minimal autorisé pour la batterie, il y a également un compromis à trouver entre le niveau d'énergie souhaité qu'on veut assurer à l'utilisateur et la puissance disponible en décharge de la batterie sur l'ensemble de la plage d'utilisation de la batterie, y compris à froid.

En termes de prestations, le système de batterie, comportant principalement les cellules et le calculateur dédié BMS (acronyme anglo-saxon pour Battery Management System), doit donc assurer un niveau d'énergie minimal requis, non seulement en début de vie, mais également après un certain nombre d'années et un niveau de puissance minimal requis, non seulement en début de vie, sur l'ensemble de la plage d'utilisation, mais également après un certain nombre d'années.

Le document de brevet WO2012074406 fait connaître une méthode de gestion de charge d'une batterie d'un véhicule électrique dans laquelle le BMS est apte à déterminer un algorithme de charge modifiable destiné à être fourni au chargeur pour assurer la charge de la batterie de façon à adapter la charge en fonction de différentes conditions telles que la température, le réseau électrique, le type de chargeur. Cette méthode permet de charger la batterie jusqu'à un niveau d'énergie souhaité dans des conditions nominales. Toutefois, elle ne permet pas de gérer toutes les causes de « dispersion » susceptible d'influer sur le niveau d'énergie disponible. En effet, une des difficultés réside dans le fait que pour une tension de fin de charge prédéterminée, l'énergie disponible pour un utilisateur n'est pas la même, en lien principalement avec trois facteurs :

- la température de la batterie : ainsi, plus la température de la batterie est basse, plus l'énergie qui peut être déchargée à partir de cette tension de de fin de charge est faible, car les résistances internes des cellules sont plus importantes ;
- le vieillissement de la batterie : plus l'état de santé de la batterie est dégradé, plus l'énergie qui peut être déchargée à partir de cette tension de fin de charge est faible, car la capacité disponible (en A.h) dans la batterie est limitée ;
- le déséquilibre cellule, défini comme étant la différence entre l'état de charge de la cellule présentant la charge la plus haute et l'état de charge de la cellule présentant la charge la plus basse : ainsi, plus le déséquilibre cellule est important, plus l'énergie qui peut être déchargée à partir de cette tension de fin de charge est faible, parce que la cellule la plus basse va atteindre sa tension limite de fin de décharge (état de charge minimal) plus tôt que les autres cellules.

Le document US 2013/184913 A1 divulgue un procédé pour contrôler la distribution de la puissance de sortie dans un véhicule hybride, présentant des inconvénients similaires.

Les documents US2012/112754 A1 et JP2014096958 A divulguent également un procédé pour contrôler la distribution de la puissance de sortie dans un véhicule hybride.

Aussi, un problème qui se pose et que vise à résoudre la présente invention est de fournir un procédé de gestion de la plage d'utilisation de la batterie permettant d'assurer au juste nécessaire le niveau d'énergie minimal requis et le niveau de puissance minimal requis, en lien avec le vieillissement de la batterie.

Dans ce but, la présente invention propose un procédé de gestion d'une plage d'utilisation autorisée d'une batterie, ladite plage d'utilisation autorisée étant bornée entre un niveau minimal et un niveau maximal d'état de charge de la batterie, ledit procédé comprenant une étape d'estimation d'un état de santé en puissance de ladite batterie, ledit état de santé en puissance caractérisant la capacité de la batterie à fournir un niveau de puissance minimal requis sur l'ensemble de ladite plage d'utilisation, ledit procédé étant caractérisé en ce qu'il comprend en outre une étape de détermination dudit niveau minimal d'état de charge de ladite batterie en fonction dudit état de santé en puissance estimé, ledit niveau minimal d'état de charge étant augmenté lorsque l'état de santé en puissance décroît.

Ainsi, grâce à cette modulation du niveau minimal d'état de charge autorisée en fonction de l'état de santé en puissance de la batterie, il est possible de compenser la diminution progressive, avec le vieillissement, de la puissance autorisée en décharge pour la batterie.

De façon à compenser la perte de capacité de la batterie, le procédé comprend également les étapes de :

- estimation d'un état de santé en énergie de ladite batterie, ledit état de santé en énergie caractérisant la capacité de ladite batterie à fournir un niveau d'énergie minimal requis sur l'ensemble de ladite plage d'utilisation ;
- détermination dudit niveau maximal d'état de charge de ladite batterie en fonction dudit état de santé en énergie estimé de ladite batterie, ledit niveau maximal d'état de charge étant augmenté lorsque l'état de santé en énergie décroît.

Avantageusement, le procédé peut comprendre en outre une étape de détermination dudit niveau maximal d'état de charge de ladite batterie en fonction dudit état de santé en puissance estimé de ladite batterie, ledit niveau maximal d'état de charge étant augmenté lorsque l'état de santé en puissance décroît. Cela permet avantageusement de compenser la diminution progressive de la puissance autorisée en décharge avec le vieillissement.

Selon une autre caractéristique avantageuse, le procédé peut comprendre une étape incluant d'abaisser ledit niveau minimal d'état de charge de ladite batterie en début de vie de ladite batterie, de manière à permettre de garantir au juste nécessaire le niveau de puissance minimal requis sur l'ensemble de la durée de vie de la batterie.

Selon une autre caractéristique avantageuse, le procédé peut aussi comprendre une étape incluant d'abaisser ledit niveau maximal d'état de charge de ladite batterie en début de vie de ladite batterie, de manière à permettre de limiter la dégradation de la batterie en début de vie en limitant sa plage d'utilisation.

Avantageusement, l'estimation dudit état de santé en puissance de ladite batterie inclut de comparer la résistance interne de la batterie dans des conditions de température et d'état de charge données avec la valeur de ladite résistance interne dans lesdites conditions lorsque la batterie est neuve.

L'invention concerne, selon un autre aspect, un programme d'ordinateur comprenant des instructions pour effectuer les étapes du procédé de l'invention, lorsque ces instructions sont exécutées par un processeur.

Le procédé de gestion de la plage d'utilisation de la batterie décrit ci-dessus peut être mis en oeuvre par des moyens numériques de traitement, par exemple un microprocesseur, un microcontrôleur ou autre. Il peut avantageusement être mis en oeuvre par le calculateur dédié du système batterie (BMS).

Il est en outre proposé un dispositif de gestion d'une plage d'utilisation autorisée d'une batterie, ladite plage d'utilisation autorisée étant bornée entre un niveau minimal et un niveau maximal d'état de charge de la batterie, ledit dispositif comprenant des moyens d'estimation d'un état de santé en puissance de ladite batterie, ledit état de santé en puissance caractérisant la capacité de ladite batterie à fournir un niveau de puissance minimal requis sur l'ensemble de ladite plage d'utilisation, et des moyens de traitement aptes à déterminer ledit niveau minimal d'état de charge de ladite batterie en fonction dudit état de santé en puissance estimé, de telle sorte que ledit niveau minimal d'état de charge augment lorsque l'état de santé en puissance de ladite batterie décroît.

Avantageusement, lesdits moyens de traitement sont aptes à déterminer ledit niveau maximal d'état de charge de ladite batterie en fonction dudit état de santé en puissance estimé de ladite batterie, de telle sorte que ledit niveau maximal d'état de charge augmente lorsque l'état de santé en puissance de ladite batterie décroît.

Le dispositif comprend également des moyens d'estimation d'un état de santé en énergie de ladite batterie, ledit état de santé en énergie caractérisant la capacité de ladite batterie à fournir un niveau d'énergie minimal requis sur l'ensemble de ladite plage d'utilisation, lesdits moyens de traitement étant aptes à déterminer ledit niveau maximal d'état de charge de ladite batterie en fonction dudit état de santé en énergie estimé de ladite batterie, de telle sorte que ledit niveau maximal d'état de charge augmente lorsque l'état de santé en énergie de ladite batterie décroît.

Ce dispositif peut par exemple comprendre ou être intégré dans un ou plusieurs processeurs.

L'invention concerne également un véhicule automobile comprenant une batterie et le dispositif de gestion de la plage d'utilisation autorisée de ladite batterie tel que décrit ci-dessus.

D'autres caractéristiques et avantages de l'invention ressortiront clairement de la description qui en est faite ci-après d'un mode de réalisation particulier de l'invention présenté à titre indicatif et nullement limitatif, en référence aux dessins annexés, dans lesquels:

- la Figure 1 représente un exemple de graphes illustrant une plage d'utilisation autorisée de la batterie dite de référence, en fonction du vieillissement de la batterie, et illustrant en parallèle, en fonction également de ce vieillissement, l'énergie disponible pour l'utilisateur à température ambiante (par exemple 25°C), ainsi que la puissance disponible au niveau minimal d'état de charge autorisé à froid ;

- la Figure 2 reprend les graphes de la Figure 1 en illustrant un exemple de gestion de la plage d'utilisation autorisée de la batterie, qui permet de fournir le niveau de prestation souhaité (énergie disponible et puissance disponible) au juste nécessaire, selon une première approche de l'invention ;

- la Figure 3 reprend les graphes de la Figure 1 en illustrant un exemple de gestion de la plage d'utilisation autorisée de la batterie, selon une deuxième approche de l'invention, qui peut être combinée avec la première approche ;
- la Figure 4 représente un graphe illustrant un mode de réalisation pour l'estimation de l'état de santé en puissance de la batterie ;
- la Figure 5 représente un graphe illustrant un mode de réalisation pour la détermination de la puissance disponible en décharge de la batterie ;
- la Figure 6 représente un graphe illustrant un exemple de cartographie de niveau minimal d'état de charge autorisé en fonction du vieillissement de la batterie ;
- la Figure 7 représente un graphe illustrant un exemple de cartographie de niveau maximal d'état de charge autorisé en fonction du vieillissement de la batterie ;
- la Figure 8 représente un graphe illustrant un exemple de détermination de la tension de fin de charge en fonction de l'état de santé en énergie de la batterie.

Les variables qui seront utilisés dans la suite de la description sont listées ci-après :

$N$ : le nombre de cellules dans la batterie.

$V_{cell}^i$ : la tension de la i-ème cellule - unité [V],

$V_{cell}^{max} = \max\left(V_{cell}^i, i \in 1..N\right)$ : la tension cellule maximale - unité [V],

$V_{cell}^{min} = \max\left(V_{cell}^i, i \in 1..N\right)$ : la tension cellule minimale - unité [V],

$BSOC$ : L'état de charge de la batterie (SOC, acronyme anglais pour State Of Charge) - unité [%],

$OCV$ : la tension à vide de la cellule - unité [V]. A une valeur de $BSOC$ et de température données, correspond un niveau d'$OCV$.

$BSOC_{min}$ : Le niveau minimal d'état de charge, au-dessous duquel la batterie n'est pas autorisée à descendre - unité [%],

$BSOC_{max}$ : Le niveau maximal d'état de charge maximal au-dessus duquel la batterie n'est pas autorisée à monter - unité [%],

$Q_{max}$ : La capacité totale de la batterie - unité [A.h.],

$SOHE$ : L'état de santé en énergie de la batterie - unité [%]. L'état de santé en énergie est révélateur de la capacité de la batterie à fournir un niveau d'énergie minimal requis et est défini dans la suite comme étant le rapport entre d'une part, l'énergie qu'on peut décharger avec la batterie pleinement chargée, à une température de référence (par exemple 25°C), à un niveau de courant constant de référence (par exemple 1C), jusqu'à l'atteinte de la tension de coupure (par exemple 2.5V) à un instant de vie donné de la batterie et, d'autre part, l'énergie qu'on peut décharger avec la batterie dans les mêmes conditions lorsqu'elle est neuve. Ainsi, en début de vie, ce rapport vaut 100%, et il diminue petit à petit. En effet, pendant la durée de vie d'une batterie, sa santé (ses performances) tend à se détériorer progressivement à cause des changements physiques et chimiques irréversibles qui ont lieu lors de l'usage et du vieillissement, jusqu'à ce que finalement la batterie ne soit plus utilisable. Le $SOHE$ reflète donc un état de santé de la batterie et sa capacité à fournir les performances spécifiées en termes d'énergie disponible par rapport à une batterie neuve.

$DCR_{cell}^i$ : la résistance interne de la cellule - unité [Ohm].

$SOHP$ : L'état de santé en puissance de la batterie - unité [%]. L'état de santé en puissance est révélateur de la capacité de la batterie à fournir un niveau de puissance minimal requis et est défini dans la suite comme étant le rapport entre d'une part, la résistance interne à 10 secondes de la batterie à une température de référence (par exemple -20°C), à un état de charge de référence (par exemple BSOC = 20%), à un instant de vie donné de la batterie et, d'autre part, la résistance interne dans les mêmes conditions lorsque la batterie est neuve. Ainsi, en début de vie, ce rapport vaut 100%, et il diminue petit à petit (du moins, au-delà d'un certain niveau de vieillissement de la batterie). Le $SOHP$ reflète donc un état de santé de la batterie et sa capacité à fournir les performances spécifiées en termes cette fois de puissance disponible autorisée en décharge pour la batterie par rapport à une batterie neuve.

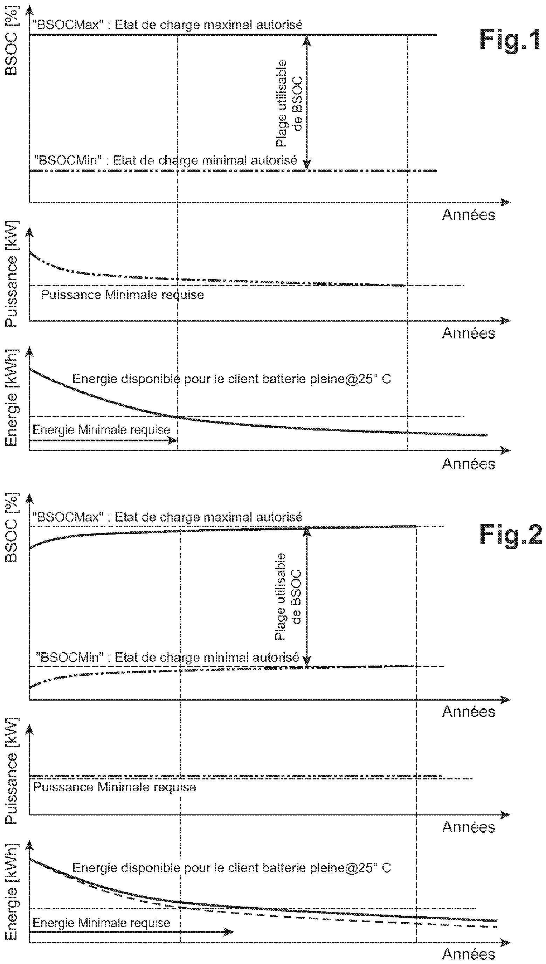

Le système BMS définit à chaque instant une plage d'utilisation autorisée pour la batterie, celle-ci pouvant éventuellement dépendre de la température. Par défaut, comme illustré sur le graphe de la figure 1, on peut considérer dans un premier temps que cette plage d'utilisation autorisé, bornée entre les niveaux minimal $BSOC_{min}$ et maximal $BSOC_{max}$ d'état de charge ne varie pas en fonction du vieillissement de la batterie. Autrement dit, les niveaux minimal $BSOC_{min}$ et maximal $BSOC_{max}$ d'état de charge autorisés demeurent figés en fonction du vieillissement de la batterie.

Dans ce cas, si la capacité de la batterie est dimensionnée pour garantir simultanément le niveau d'énergie minimal requis à température ambiante pendant une durée minimale (typiquement 2 ans) et le niveau de puissance minimal requis à $BSOC_{min}$ à froid (typiquement à -20°C), alors, en début de vie de la batterie, il s'avère, comme illustré sur les graphes de la figure 1, que l'utilisateur dispose à la fois d'un surplus de puissance disponible à $BSOC_{min}$ à froid (typiquement à -20°C) et d'un surplus d'énergie disponible à température ambiante.

Ainsi, comme illustré sur les graphes de la figure 2, une première voie d'optimisation de la gestion de la plage d'utilisation de la batterie consiste à définir un niveau de $BSOC_{min}$ plus bas en début de vie de la batterie pour garantir au juste nécessaire le niveau de puissance minimal requis sur l'ensemble de la durée de vie de la batterie. En complément de cette approche, on peut diminuer également $BSOC_{max}$, tout en maintenant le même niveau d'énergie disponible pour l'utilisateur par rapport à la configuration de plage d'utilisation de la batterie illustrée à la figure 1. Cette diminution du niveau maximal d'état de charge autorisé permet d'améliorer sensiblement la durabilité de la batterie, car au moins en début de vie de la batterie, la batterie passera moins de temps à haut état de charge (ce qui est dégradant en pratique pour la batterie). Par contre, en début de vie de la batterie, comme illustré sur le graphe de la figure 2 représentant l'énergie disponible pour l'utilisateur à température ambiante en fonction du vieillissement, l'utilisateur aura quand même potentiellement un surplus d'énergie disponible inutile par rapport au niveau minimal d'énergie requis. Aussi, si cette première voie d'optimisation permet de garantir au juste nécessaire le niveau de prestation souhaité en termes de puissance disponible par rapport au niveau de puissance minimal requis sur l'ensemble de la durée de vie de la batterie, elle ne permet toutefois pas de fournir le niveau de prestation souhaité en termes d'énergie disponible au juste nécessaire par rapport au niveau minimal d'énergie requis.

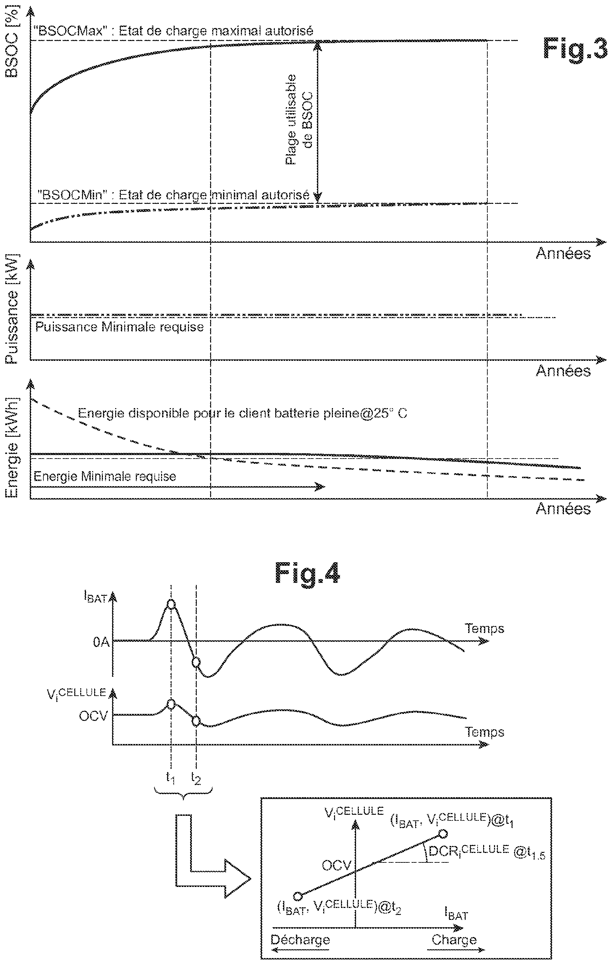

Aussi, comme illustré sur les graphes de la figure 3, une deuxième voie d'optimisation de la gestion de la plage d'utilisation de la batterie consiste à réduire de manière additionnelle $BSOC_{max}$ en début de vie de la batterie pour garantir au juste nécessaire l'énergie disponible pour l'utilisateur par rapport au niveau d'énergie minimal requis sur l'ensemble de la durée de vie de la batterie. Cette diminution additionnelle du niveau maximal d'état de charge autorisé $BSOC_{max}$ permet d'améliorer la durabilité de la batterie, car au moins en début de vie de la batterie, celle-ci passera encore moins de temps de temps à haut état de charge (ce qui est dégradant en pratique pour la batterie). Cette deuxième voie d'optimisation peut être combinée avec la première voie d'optimisation exposée ci-dessus, pour un gain supplémentaire de durabilité de la batterie.

Par rapport à ce qui précède, selon un mode de réalisation préférentiel, le système BMS est donc conçu pour mettre en oeuvre une logique de modulation du niveau minimal d'état de charge autorisé de la batterie $BSOC_{min}$ en fonction de l'état de santé en puissance de la batterie $SOHP$, de façon à compenser la diminution progressive de la puissance autorisée en décharge pour la batterie avec le vieillissement. Plus précisément, le niveau minimal d'état de charge autorisé est augmenté en fonction de l'état de vieillissement croissant de la batterie jusqu'à une valeur limite pour assurer le niveau de puissance minimal requis pendant toute la durée de vie de la batterie. Comme indiqué sur les figures 2 et 3, plus la batterie vieillit, plus il convient d'augmenter le niveau minimal d'état de charge $BSOC_{min}$ pour compenser la perte de puissance disponible en décharge. Dit autrement, le niveau minimal d'état de charge croît lorsque l'état de santé en puissance de la batterie décroît.

En outre, le système BMS est préférentiellement conçu pour mettre en oeuvre une logique de modulation du niveau maximal d'état de charge autorisé de la batterie $BSOC_{max}$ en fonction de l'état de santé en énergie de la batterie $SOHE$, de façon à compenser la perte de capacité totale de la batterie et ainsi maintenir un niveau d'énergie minimal requis sur une durée suffisamment longue tout en préservant la durabilité.

Ainsi, le niveau minimal d'état de charge au-dessous duquel la batterie n'est pas autorisée à descendre est géré, selon l'invention, à partir du calcul de l'état de santé en puissance de la batterie, qui dépend du vieillissement. Le principe général du calcul de l'état de santé en puissance de la batterie est décrit en référence à la figure 4. Ainsi, on compare la variation du courant $\Delta I_{bat}$ pendant une période de temps bornée entre les instants $t_1$ et $t_2$, par exemple égale à 10 secondes, avec la variation de la tension cellule $\Delta V_{cell}$. Le rapport entre ces deux variations correspond alors à la résistance apparente de la cellule $RESISTANCE_{apparente}^{cellule}$. A noter que si cette résistance est déterminée sur une plage de fréquence spécifique, on parlera plutôt d'impédance cellule. A partir de cette information, le système BMS est prévu pour comparer cette résistance apparente à la valeur de la résistance interne qu'aurait eue cette cellule si elle avait été neuve $RESISTANCE_{NEUVE}^{cellule}$ dans les mêmes conditions. En pratique, le système BMS calcule alors l'état de santé en puissance de la batterie *SOHP* de la façon suivante : $SOHP = \dfrac{RESISTANCE_{NEUVE}^{cellule}}{RESISTANCE_{apparente}^{cellule}}$ , qui définit ainsi un rapport caractérisant l'augmentation de la résistance interne de la cellule.

On pourra choisir de déterminer une valeur de *SOHP* unique valable sur l'ensemble de la plage de température et d'état de charge ou bien on pourra choisir de déterminer des valeurs de *SOHP* en fonction de la température batterie.

Le système BMS est alors prévu pour déterminer le niveau minimal d'état de charge autorisé pour la batterie en fonction de l'état de santé en puissance de la batterie ainsi estimé.

La puissance disponible en décharge correspond à la valeur maximale de puissance que sait fournir la batterie d'une part, sans tomber au-dessous d'un niveau de tension de coupure $V_{\min}$ et, d'autre part, sans dépasser un courant maximal de déchargea $I_{bat\_MAX}$.

Aussi, mathématiquement, la puissance disponible en décharge à partir d'un niveau d'état de charge peut être calculée de la façon suivante :

$$PuissanceDisponible = \min\left( V_{\min} \cdot \frac{OCV - V_{\min}}{DCR}, \left(OCV - DCR \cdot I_{bat\_MAX}\right) \cdot I_{bat\_MAX}\right)$$

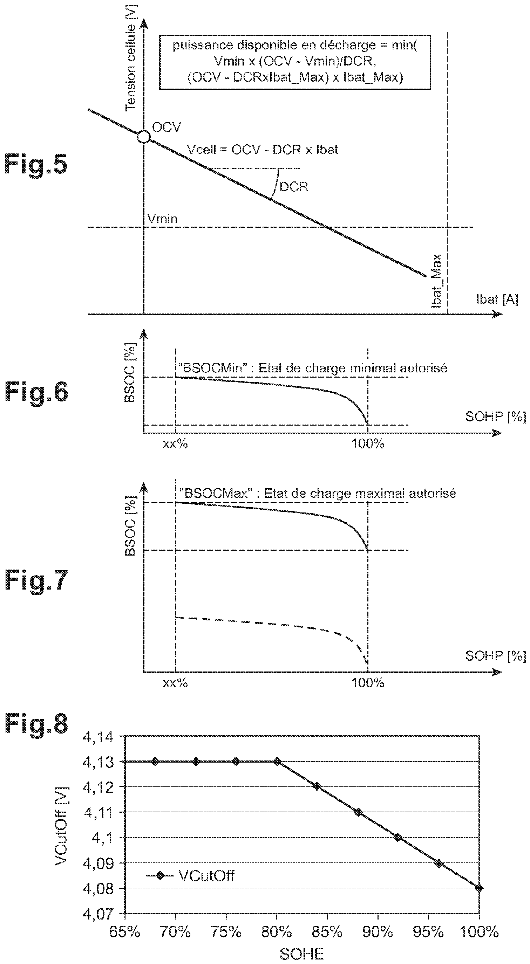

Ainsi, comme illustré en référence à la figure 5, la puissance disponible en décharge dépend directement de la résistance interne de la batterie. Si on prend en compte l'état de santé en puissance *SOHP* de la batterie, ainsi que le niveau de la résistance interne de la batterie en début de vie $DCR_{BOL}$, on obtient :

$$PuissanceDisponible = \min\left( V_{\min} \cdot \frac{OCV - V_{\min}}{\dfrac{DCR_{BOL}}{SOHP}}, \left( OCV - \frac{DCR_{BOL}}{SOHP} \cdot I_{bat\_MAX}\right) \cdot I_{bat\_MAX}\right)$$

Il apparaît qu'une diminution de l'état de santé en puissance de la batterie *SOHP* avec le vieillissement de la batterie se traduit par une diminution de la puissance disponible pour un état de charge donné. Aussi, pour une batterie vieillie, c'est-à-dire présentant un *SOHP* inférieur à 100%, pour assurer le niveau de puissance minimal requis, il faut augmenter la tension à vide *OCV* et, par conséquent, augmenter le niveau minimal d'état de charge $BSOC_{\min}$.

Ainsi, à chaque température (a fortiori à froid), et pour chaque niveau de *SOHP,* on peut déterminer le niveau minimal d'état de charge $BSOC_{\min}$ permettant d'assurer la puissance minimale requise. Comme illustré sur la figure 6, on peut donc en déduire une cartographie de niveau minimal d'état de charge autorisé $BSOC_{\min}$ en fonction du vieillissement et, plus particulièrement, en fonction de l'évolution de l'état de santé en puissance de la batterie *SOHP,* d'où il apparaît que le niveau minimal d'état de charge autorisé est croissant quand l'état de santé en puissance de la batterie décroît.

Le système BMS est aussi prévu pour réaliser une estimation de l'état de santé en énergie de la batterie *SOHE.* Il existe plusieurs méthodes pour estimer l'état de santé en énergie de la batterie. A titre d'exemple, on pourra utiliser pour cette estimation l'une des méthodes exposées dans le brevet "METHOD AND APPARATUS OF ESTIMATING STATE OF HEALTH OF BATTERY" (US2007/0001679 A1) ou dans l'article « R. Spotnitz, "Simulation of capacity fade in lithium ion batteries", Journal of Power Sources 113 (2003) 72-80. »

On a vu plus haut qu'en complément de la première voie d'optimisation consistant en une modulation du niveau minimal d'état de charge autorisé $BSOC_{\min}$ en fonction de l'état de santé en puissance *SOHP* pour garantir au juste nécessaire le niveau de puissance minimal requis sur l'ensemble de la durée de vie de la batterie, on peut également moduler le niveau maximal d'état de charge autorisé $BSOC_{\max}$ en fonction de l'état de santé en puissance *SOHP,* afin de rester à iso-énergie par rapport à la configuration de la plage d'utilisation de référence illustrée à la figure 1. En première approximation, on peut donc considérer qu'on souhaite conserver un écart d'état de charge constant entre $BSOC_{\max}$ et $BSOC_{\min}$ sur l'ensemble de la durée de vie de la batterie, comme illustré en figure 7. Dans la mesure où un Ampère.heure à bas état de charge est plus énergétique qu'un Ampère.heure à haut état de charge, il sera possible de modifier légèrement cet écart entre $BSOC_{\max}$ et $BSOC_{\min}$, tout en gardant le principe de continuer à déterminer le niveau maximal d'état de charge autorisé $BSOC_{\max}$ exclusivement à partir de l'état de santé en puissance de la batterie *SOHP.*

Dans le cadre de la deuxième voie d'optimisation de la gestion de la plage d'utilisation de la batterie exposée plus haut, le niveau maximal d'état de charge autorisé de la batterie $BSOC_{\max}$ est déterminé afin d'assurer le niveau d'énergie requis au juste nécessaire. Cela revient à le déterminer, non plus en fonction de l'état de santé en puissance de la batterie *SOHP,* mais en fonction de l'état de santé en énergie de la batterie *SOHE.* Pour ce faire, une cartographie *VcutOff = f*(*SOHE*), implémentée dans le BMS, permet de déterminer la tension de fin de charge *VCutOff* à partir du *SOHE* estimé de la manière exposée plus haut et permet de compenser la perte de capacité de la batterie (diminution de l'état de santé en énergie de la batterie *SOHE*) par une augmentation de la tension de fin de charge *VCutOff,* comme illustré à la figure 8. Ainsi, la tension de fin de charge et donc le niveau maximal d'état de charge autorisé est augmenté en fonction de l'état de vieillissement croissant de la batterie (état de santé en énergie décroissant) jusqu'à une valeur limite pour assurer le niveau d'énergie minimal requis, constant, pendant toute la durée de vie de la batterie.

Le niveau maximal d'état de charge autorisé pour la batterie $BSOC_{max}$ pourra ainsi non seulement être déterminé en fonction de l'état de santé en énergie de la batterie *SOHE*, comme il vient juste d'être expliqué, mais également en fonction de l'état de santé en puissance de la batterie *SOHP* et ce, comme il a été expliqué plus haut, afin de prendre en compte le fait que le niveau minimal d'état de charge $BSOC_{min}$ augmente en lien avec une diminution de l'état de santé en puissance de la batterie *SOHP*, et ainsi maintenir le même niveau d'énergie pour l'utilisateur par rapport à la plage d'utilisation de référence. Pour ce faire, il peut être utile de prendre en compte le fait qu'il existe une corrélation entre l'évolution de *SOHP* et de *SOHE,* cette corrélation pouvant être déterminée de manière empirique sur la base d'essais réalisés sur des cellules (en off-line). Autrement dit, pour gérer le niveau maximal d'état de charge au-dessus duquel la batterie n'est pas autorisée à monter, le système BMS est conçu pour mettre en oeuvre une logique de modulation du niveau maximal d'état de charge autorisé $BSOC_{max}$, soit en fonction du calcul du *SOHP* seul, soit en fonction du calcul du *SOHE* seul, soit encore en fonction d'une combinaison des deux (*SOHP* et *SOHE*).

La stratégie de gestion optimisée de la plage d'utilisation de la batterie selon l'invention permet ainsi, en début de vie, d'assurer au juste nécessaire le niveau d'énergie minimal requis et le niveau de puissance minimal requis en bridant la batterie (c'est-à-dire sa plage d'utilisation) au juste nécessaire, aussi bien pour le niveau minimal d'état de charge autorisé que pour le niveau maximal d'état de charge autorisé. Sur les premières années d'utilisation du véhicule, cette stratégie permet de compenser la perte de puissance disponible en décharge en augmentant peu à peu le niveau minimal d'état de charge au-dessous duquel la batterie n'est pas autorisée à descendre. En outre, en limitant la plage d'utilisation de la batterie en début de vie et en augmentant petit à petit la tension de fin de charge (donc le niveau maximal d'état de charge autorisé) en fonction du vieillissement, elle permet également, sur les premières années d'utilisation du véhicule, de compenser la perte de capacité de la batterie. Cette stratégie permet avantageusement de masquer le fait que la batterie se dégrade (en termes de puissance disponible et en termes d'énergie disponible), au moins durant les premières années, et permet en outre de limiter en début de vie la dégradation de la batterie, puisqu'on l'utilise sur une plage de fonctionnement limitée (avec une tension de fin de charge abaissée).

**Revendications**

1. Procédé de gestion d'une plage d'utilisation autorisée d'une batterie, ladite plage d'utilisation autorisée étant bornée entre un niveau minimal ($BSOC_{min}$) et un niveau maximal ($BSOC_{max}$) d'état de charge de la batterie, ledit procédé comprenant une étape d'estimation d'un état de santé en puissance (*SOHP*) de ladite batterie, ledit état de santé en puissance caractérisant la capacité de ladite batterie à fournir un niveau de puissance minimal requis sur l'ensemble de ladite plage d'utilisation, ledit procédé comprenant une étape de détermination dudit niveau minimal d'état de charge ($BSOC_{min}$) de ladite batterie en fonction dudit état de santé en puissance estimé (*SOHP*), ledit niveau minimal d'état de charge étant augmenté lorsque l'état de santé en puissance décroît, ledit procédé étant **caractérisé en ce qu'**il comprend en outre des étapes de :

   - estimation d'un état de santé en énergie (*SOHE*) de ladite batterie, ledit état de santé en énergie caractérisant la capacité de ladite batterie à fournir un niveau d'énergie minimal requis sur l'ensemble de ladite plage d'utilisation ;
   - détermination dudit niveau maximal d'état de charge ($BSOC_{max}$) de ladite batterie en fonction dudit état de santé en énergie estimé de ladite batterie, ledit niveau maximal d'état de charge étant augmenté lorsque l'état de santé en énergie décroît.

2. Procédé selon la revendication 1, comprenant une étape de détermination dudit niveau maximal d'état de charge ($BSOC_{max}$) de ladite batterie en fonction dudit état de santé en puissance (*SOHP*) estimé de ladite batterie, ledit niveau maximal d'état de charge étant augmenté lorsque l'état de santé en puissance décroît.

3. Procédé selon l'une quelconque des revendications précédentes, comprenant une étape incluant d'abaisser ledit niveau minimal d'état de charge ($BSOC_{min}$) de ladite batterie en début de vie de ladite batterie.

**4.** Procédé selon l'une quelconque des revendications précédentes, comprenant une étape incluant d'abaisser ledit niveau maximal d'état de charge ($BSOC_{max}$) de ladite batterie en début de vie de ladite batterie.

**5.** Procédé selon l'une quelconque des revendications précédentes, dans lequel l'estimation dudit état de santé en puissance ($SOHP$) de ladite batterie inclut de comparer la résistance interne de la batterie dans des conditions de température et d'état de charge données avec la valeur de ladite résistance interne dans lesdites conditions lorsque la batterie est neuve.

**6.** Dispositif de gestion d'une plage d'utilisation autorisée d'une batterie, ladite plage d'utilisation autorisée étant bornée entre un niveau minimal ($BSOC_{min}$) et un niveau maximal ($BSOC_{max}$) d'état de charge de la batterie, ledit dispositif comprenant des moyens d'estimation d'un état de santé en puissance *(SOHP)* de ladite batterie, ledit état de santé en puissance caractérisant la capacité de ladite batterie à fournir un niveau de puissance minimal requis sur l'ensemble de ladite plage d'utilisation, et des moyens de traitement aptes à déterminer ledit niveau minimal d'état de charge de ladite batterie en fonction dudit état de santé en puissance estimé, de telle sorte que ledit niveau minimal d'état de charge augmente lorsque l'état de santé en puissance de ladite batterie décroît, ledit dispositif comprenant en outre des moyens d'estimation d'un état de santé en énergie ($SOHE$) de ladite batterie, ledit état de santé en énergie caractérisant la capacité de ladite batterie à fournir un niveau d'énergie minimal requis sur l'ensemble de ladite plage d'utilisation, lesdits moyens de traitement étant aptes à déterminer ledit niveau maximal d'état de charge ($BSOC_{max}$) de ladite batterie en fonction dudit état de santé en énergie estimé de ladite batterie, de telle sorte que ledit niveau maximal d'état de charge augmente lorsque l'état de santé en énergie de ladite batterie décroît.

**7.** Dispositif selon la revendication 6, **caractérisé en ce que** lesdits moyens de traitement sont aptes à déterminer ledit niveau maximal d'état de charge ($BSOC_{max}$) de ladite batterie en fonction dudit état de santé en puissance estimé de ladite batterie, de telle sorte que ledit niveau maximal d'état de charge augmente lorsque l'état de santé en puissance de ladite batterie décroît.

**8.** Véhicule automobile comprenant une batterie et un dispositif de gestion de la plage d'utilisation autorisée de ladite batterie selon l'une quelconque des revendications 6 et 7.

**Patentansprüche**

**1.** Verfahren zur Verwaltung eines zulässigen Betriebsbereichs einer Batterie, wobei der zulässige Betriebsbereich von einem minimalen Niveau ($BSOC_{min}$) und einem maximalen Niveau ($BSOC_{max}$) des Ladezustands der Batterie begrenzt wird, wobei das Verfahren einen Schritt der Schätzung eines leistungsbezogenen Alterungszustands ($SOHP$) der Batterie umfasst, wobei der leistungsbezogene Alterungszustand die Fähigkeit der Batterie charakterisiert, ein erforderliches minimales Leistungsniveau im gesamten Betriebsbereich zu liefern, wobei das Verfahren einen Schritt der Bestimmung des minimalen Niveaus des Ladezustands ($BSOC_{min}$) der Batterie in Abhängigkeit von dem geschätzten leistungsbezogenen Alterungszustand ($SOHP$) umfasst, wobei das minimale Niveau des Ladezustands erhöht wird, wenn der leistungsbezogene Alterungszustand abnimmt, wobei das Verfahren **dadurch gekennzeichnet ist, dass** es außerdem Schritte umfasst:

- der Schätzung eines energiebezogenen Alterungszustands ($SOHE$) der Batterie, wobei der energiebezogene Alterungszustand die Fähigkeit der Batterie charakterisiert, ein erforderliches minimales Energieniveau im gesamten Betriebsbereich zu liefern;
- der Bestimmung des maximalen Niveaus des Ladezustands ($BSOC_{max}$) der Batterie in Abhängigkeit von dem geschätzten energiebezogenen Alterungszustand der Batterie, wobei das maximale Niveau des Ladezustands erhöht wird, wenn der energiebezogene Alterungszustand abnimmt.

**2.** Verfahren nach Anspruch 1, welches einen Schritt der Bestimmung des maximalen Niveaus des Ladezustands ($BSOC_{max}$) der Batterie in Abhängigkeit von dem geschätzten leistungsbezogenen Alterungszustand ($SOHP$) der Batterie umfasst, wobei das maximale Niveau des Ladezustands erhöht wird, wenn der leistungsbezogene Alterungszustand abnimmt.

**3.** Verfahren nach einem der vorhergehenden Ansprüche, welches einen Schritt umfasst, der beinhaltet, das minimale Niveau des Ladezustands ($BSOC_{min}$) der Batterie zu Beginn der Lebensdauer der Batterie zu senken.

**4.** Verfahren nach einem der vorhergehenden Ansprüche, welches einen Schritt umfasst, der beinhaltet, das maximale Niveau des Ladezustands ($BSOC_{max}$) der Batterie zu Beginn der Lebensdauer der Batterie zu senken.

**5.** Verfahren nach einem der vorhergehenden Ansprüche, wobei die Schätzung des leistungsbezogenen Alterungszustands ($SOHP$) der Batterie beinhaltet, den inneren Widerstand der Batterie unter gegebenen Bedingungen der Temperatur und des Ladezustands mit dem Wert dieses inneren Widerstands unter diesen Bedingungen, wenn die Batterie neu ist, zu vergleichen.

**6.** Vorrichtung zur Verwaltung eines zulässigen Betriebsbereichs einer Batterie, wobei der zulässige Betriebsbereich von einem minimalen Niveau ($BSOC_{min}$) und einem maximalen Niveau ($BSOC_{max}$) des Ladezustands der Batterie begrenzt wird, wobei die Vorrichtung Mittel zur Schätzung eines leistungsbezogenen Alterungszustands ($SOHP$) der Batterie umfasst, wobei der leistungsbezogene Alterungszustand die Fähigkeit der Batterie charakterisiert, ein erforderliches minimales Leistungsniveau im gesamten Betriebsbereich zu liefern, und Verarbeitungsmittel, die geeignet sind, das minimale Niveau des Ladezustands der Batterie in Abhängigkeit von dem geschätzten leistungsbezogenen Alterungszustand zu bestimmen, derart, dass sich das minimale Niveau des Ladezustands erhöht, wenn der leistungsbezogene Alterungszustand der Batterie abnimmt, wobei die Vorrichtung außerdem Mittel zur Schätzung eines energiebezogenen Alterungszustands ($SOHE$) der Batterie umfasst, wobei der energiebezogene Alterungszustand die Fähigkeit der Batterie charakterisiert, ein erforderliches minimales Energieniveau im gesamten Betriebsbereich zu liefern, wobei die Verarbeitungsmittel geeignet sind, das maximale Niveau des Ladezustands ($BSOC_{max}$) der Batterie in Abhängigkeit von dem geschätzten energiebezogenen Alterungszustand der Batterie zu bestimmen, derart, dass sich das maximale Niveau des Ladezustands erhöht, wenn der energiebezogene Alterungszustand der Batterie abnimmt.

**7.** Vorrichtung nach Anspruch 6, **dadurch gekennzeichnet, dass** die Verarbeitungsmittel geeignet sind, das maximale Niveau des Ladezustands ($BSOC_{max}$) der Batterie in Abhängigkeit von dem geschätzten leistungsbezogenen Alterungszustand der Batterie zu bestimmen, derart, dass sich das maximale Niveau des Ladezustands erhöht, wenn der leistungsbezogene Alterungszustand der Batterie abnimmt.

**8.** Kraftfahrzeug, welches eine Batterie und eine Vorrichtung zur Verwaltung des zulässigen Betriebsbereichs der Batterie nach einem der Ansprüche 6 und 7 umfasst.

**Claims**

**1.** Method for managing a permissible operating range of a battery, said permissible operating range being bounded between a minimum level ($BSOC_{min}$) and a maximum level ($BSOC_{max}$) of state of charge of the battery, said method comprising a step of estimating a state of health in terms of power ($SOHP$) of said battery, said state of health in terms of power characterizing the capacity of said battery to supply a required minimum power level over the entirety of said operating range, said method comprising a step of determining said minimum level of state of charge ($BSOC_{min}$) of said battery as a function of said estimated state of health in terms of power ($SOHP$), said minimum level of state of charge being increased when the state of health in terms of power decreases, said method being **characterized in that** it furthermore comprises steps of:

- estimating a state of health in terms of energy ($SOHE$) of said battery, said state of health in terms of energy characterizing the capacity of said battery to supply a required minimum energy level over the entirety of said operating range;
- determining said maximum level of state of charge ($BSOC_{max}$) of said battery as a function of said estimated state of health in terms of energy of said battery, said maximum level of state of charge being increased when the state of health in terms of energy decreases.

**2.** Method according to Claim 1, comprising a step of determining said maximum level of state of charge ($BSOC_{max}$) of said battery as a function of said estimated state of health in terms of power ($SOHP$) of said battery, said maximum level of state of charge being increased when the state of health in terms of power decreases.

**3.** Method according to either one of the preceding claims, comprising a step including reducing said minimum level of state of charge ($BSOC_{min}$) of said battery at the start of life of said battery.

**4.** Method according to any one of the preceding claims, comprising a step including reducing said maximum level of state of charge ($BSOC_{max}$) of said battery at the start of life of said battery.

5. Method according to any one of the preceding claims, wherein the estimation of said state of health in terms of power ($SOHP$) of said battery includes comparing the internal resistance of the battery in given temperature and state of charge conditions with the value of said internal resistance in said conditions when the battery is new.

6. Device for managing a permissible operating range of a battery, said permissible operating range being bounded between a minimum level ($BSOC_{min}$) and a maximum level ($BSOC_{max}$) of state of charge of the battery, said device comprising means for estimating a state of health in terms of power ($SOHP$) of said battery, said state of health in terms of power characterizing the capacity of said battery to supply a required minimum power level over the entirety of said operating range, and processing means able to determine said minimum level of state of charge of said battery as a function of said estimated state of health in terms of power, such that said minimum level of state of charge increases when the state of health in terms of power of said battery decreases, said device furthermore comprising means for estimating a state of health in terms of energy ($SOHE$) of said battery, said state of health in terms of energy characterizing the capacity of said battery to supply a required minimum energy level over the entirety of said operating range, said processing means being able to determine said maximum level of state of charge ($BSOC_{max}$) of said battery as a function of said estimated state of health in terms of energy of said battery, such that said maximum level of state of charge increases when the state of health in terms of energy of said battery decreases.

7. Device according to Claim 6, **characterized in that** said processing means are able to determine said maximum level of state of charge ($BSOC_{max}$) of said battery as a function of said estimated state of health in terms of power of said battery, such that said maximum level of state of charge increases when the state of health in terms of power of said battery decreases.

8. Motor vehicle comprising a battery and a device for managing the permissible operating range of said battery according to either one of claims 6 and 7.

## Fig.1

"BSOCMax" : Etat de charge maximal autorisé

Plage utilisable de BSOC

"BSOCMin" : Etat de charge minimal autorisé

BSOC [%]

Années

Puissance [kW]

Puissance Minimale requise

Années

Energie [kWh]

Energie disponible pour le client batterie pleine@25° C

Energie Minimale requise

Années

## Fig.2

"BSOCMax" : Etat de charge maximal autorisé

Plage utilisable de BSOC

"BSOCMin" : Etat de charge minimal autorisé

BSOC [%]

Années

Puissance [kW]

Puissance Minimale requise

Années

Energie [kWh]

Energie disponible pour le client batterie pleine@25° C

Energie Minimale requise

Années

# Fig.3

BSOC [%]

"BSOCMax" : Etat de charge maximal autorisé

Plage utilisable de BSOC

"BSOCMin" : Etat de charge minimal autorisé

Années

Puissance [kW]

Puissance Minimale requise

Années

Energie [kWh]

Energie disponible pour le client batterie pleine@25° C

Energie Minimale requise

Années

# Fig.4

$I_{BAT}$

0A

Temps

$V_i^{CELLULE}$

OCV

Temps

$t_1$  $t_2$

$V_i^{CELLULE}$

$(I_{BAT}, V_i^{CELLULE})@t_1$

$DCR_i^{CELLULE}$ @$t_{1.5}$

OCV

$(I_{BAT}, V_i^{CELLULE})@t_2$

$I_{BAT}$

Décharge

Charge

**Fig.5**

Tension cellule [V]

puissance disponible en décharge = min(
Vmin x (OCV - Vmin)/DCR,
(OCV - DCRxIbat_Max) x Ibat_Max)

OCV

Vcell = OCV - DCR x Ibat

DCR

Vmin

Ibat_Max

Ibat [A]

**Fig.6**

BSOC [%]

"BSOCMin" : Etat de charge minimal autorisé

SOHP [%]

xx%          100%

**Fig.7**

BSOC [%]

"BSOCMax" : Etat de charge maximal autorisé

SOHP [%]

xx%          100%

**Fig.8**

VCutOff [V]

4,14
4,13
4,12
4,11
4,1
4,09
4,08
4,07

VCutOff

65%   70%   75%   80%   85%   90%   95%   100%

SOHE

**EP 3 191 337 B1**

## RÉFÉRENCES CITÉES DANS LA DESCRIPTION

**Documents brevets cités dans la description**

- WO 2012074406 A
- US 2013184913 A1
- US 2012112754 A1
- JP 2014096958 A
- US 20070001679 A1

**Littérature non-brevet citée dans la description**

- **R. SPOTNITZ.** Simulation of capacity fade in lithium ion batteries. *Journal of Power Sources,* 2003, vol. 113, 72-80